# EUROPEAN PATENT APPLICATION

(11) **EP 4 715 521 A1**
(43) Date of publication of application: **25.03.2026**
(21) Application number: 24223790.7
(22) Date of filing: 30.12.2024
(51) Int. Cl.: G06F 1/20, H05K 7/20, H01L 23/427, H01L 23/473

(54) **LIQUID COOLING HEAT DISSIPATION DEVICE FOR ELECTRONIC/COMPUTER PRODUCTS**

(30) Priority: 18.09.2024 TW 113135349
(71) Applicant: SINTRONES Technology Corp., New Taipei City 235 (TW)
(72) Inventor: Hsu, Yu-Jui, 235 New Taipei City (TW); Hsu, Wen-Sung, 235 New Taipei City (TW)
(74) Representative: JD&P Patent Attorneys Joanna Dargiewicz & Partners

(57) **Abstract**

A liquid cooling dissipation device for electronic/computer products includes a top cover with a coolant cold plate and two cooling brackets. The cold plate has at least two sets of flow channels for accommodating coolant and connects to multiple heating elements. It features inlets and outlets at both ends, all connected to the flow channels. Tubes with mounting brackets at the top end are installed at these points. A condenser, mounted on the mounting brackets and featuring side brackets, includes at least two cooling flow channels, multiple heat-conducting plates, and several heat dissipation fins. The cold plate consists of four laminated layers: a first-layer bottom plate, a second-layer composite plate, a third-layer metal plate, and a fourth-layer top plate. Heat from the heating elements vaporizes the coolant, which the condenser returns to liquid, circulating via siphon effect and pressure differential.

## Description

### FIELD OF THE INVENTION

The present invention relates to a heat dissipation device, specifically a liquid cooling heat dissipation device for electronic/computer products that utilizes the siphon effect and pressure differential to induce circulation of a coolant submerged with heating elements in flow channels, where the coolant vaporizes upon heating and cools down to liquid form without the need for an energy-consuming pump.

### BACKGROUND OF THE INVENTION

In general, heat sinks commonly used in electronic/computer products, IoT systems, surveillance systems, warehouse management, or inventory management primarily feature a motherboard equipped with high-end CPU and GPU components on an aluminum extrusion. This setup utilizes multiple fins located on the top and sides of the aluminum extrusion to conduct heat from the high-end CPU and GPU components, thereby enlarging the heat dissipation area of the fins. The fins, in contact with the air, facilitate the transfer of heat away through air circulation. Since the fins use passive cooling, their cooling efficiency is poor. To rapidly dissipate the heat from the fins into the air, powerful fans are often mounted on the fins of the aluminum extrusion. The addition of these fans increases the cost of the heat sinks and consumes more energy. The aluminum extrusions, designed with fins at the top and periphery, along with fans mounted at the top, not only increase the cost of using these components but also heighten the likelihood of fan failures. The conventional use of aluminum extrusions in direct thermal contact with high-end CPUs and GPUs is similarly ineffective, significantly compromising practicality. This is a critical area that both manufacturers and consumers are eager to improve.

### SUMMARY OF THE INVENTION

To address the deficiencies in the existing technology, the primary objective of this invention is to provide a liquid cooling heat dissipation device for electronic/computer products. This device includes a top cover, tubes, and a condenser. The top cover contains a coolant cold plate and cooling brackets located on both sides of the coolant cold plate. The coolant cold plate is equipped with flow channels and multiple heating elements that are connected to these flow channels. The coolant cold plate has outlets and inlets connected to the flow channels, with tubes located at the upper end. The upper end of the tube is connected to a condenser that communicates with the tube. This design aims to overcome the difficulties present in existing technologies.

A secondary objective of this invention is to provide a liquid cooling heat dissipation device for electronic/computer products, which utilizes heating elements to heat the coolant in the flow channels, causing the low-temperature liquid coolant to absorb heat and vaporize. The vaporized coolant rises through the tubes to the condenser where it is cooled back to liquid form. Utilizing the siphon principle and generating a pressure differential, the coolant then circulates downward through the opposing tubes and re-enters the flow channels of the coolant cold plate, where it absorbs heat from the heating elements.

Another objective of this invention is to provide a liquid cooling heat dissipation device for electronic/computer products that enhances user convenience. It operates without the need for energy-consuming fans, allows for rapid cooling, and reduces costs.

The problem that this invention aims to solve involves the heat sinks commonly used in electronic/computer products, IoT systems, surveillance systems, warehouse management, or inventory management. These systems typically feature a motherboard with high-end CPU and GPU components mounted on an aluminum extrusion, utilizing multiple fins on the top and sides of the extrusion, or additional powerful fans mounted on these fins. This setup facilitates heat transfer from the high-end CPU and GPU components to the aluminum extrusion and then to the enlarged heat dissipation area of the fins, or through the air blown by the powerful fans. However, the cooling performance is poor; whether fins are used on the top of the aluminum extrusion or powerful fans are added, both increase the cost of the heat sinks and the components, consume more energy, and are prone to fan failures, significantly reducing their practicality.

To solve the identified problems and achieve the stated objectives, this invention introduces a liquid cooling heat dissipation device for electronic/computer products, comprising:
A top cover, comprising a coolant cold plate and two cooling brackets, the cooling brackets located on both sides of the coolant cold plate, the coolant cold plate comprising at least two sets of a flow channel accommodating coolant and multiple heating elements connected thereto, the coolant cold plate having staggered ends, and featuring an inlet and an outlet at one end and another pair positioned oppositely at the other end, all connected to the flow channel;
Multiple tubes, which are respectively installed at the outlet and inlet of the coolant cold plate on the top cover. Said tubes have a mounting bracket at the upper end that connects to the outlet and inlet.
A condenser, mounted on the mounting bracket of the tube, the condenser having a side bracket located between its sides and the upper end of the coolant cold plate, comprising at least two cooling flow channels, multiple heat-conducting plates, and multiple heat dissipation fins, the cooling flow channels being closed at both ends and spanning across to connect with the mounting bracket of the tube, the heat-conducting plates being sheathed at both ends in the cooling flow channels, and the heat dissipation fins being bent and connected between pairs of opposing heat-conducting plates;
Utilizing heat from the heating elements, the low-temperature liquid coolant in the flow channels absorbs heat and vaporizes, rising through the tube to the condenser where it cools back to liquid form. The siphon effect and pressure differential facilitate circulation as it descends through the opposing tube and enters the flow channels of the coolant cold plate.

Wherein, the cooling brackets of the top cover of the present invention are equipped with multiple heat sinks.

Wherein, the coolant cold plate comprises a first-layer bottom plate, a second-layer composite plate, a third-layer metal plate, and a fourth-layer top plate laminated together, the second-layer composite plate and the third-layer metal plate having at least two sets of flow channels accommodating coolant, and the fourth-layer top plate being provided with the outlet and the inlet, both of which are connected to the flow channels of the second-layer composite plate and the third-layer metal plate.

Wherein, the third-layer metal plate of the coolant cold plate is, but is not limited to, an aluminum plate.

Wherein, the top cover of the present invention is, but is not limited to, a metal cover.

Wherein, the metal top cover of the present invention is, but is not limited to, an aluminum extruded cover.

Wherein, the first-layer bottom plate, the second-layer composite plate, the third-layer metal plate, and the fourth-layer top plate of the coolant cold plate of the present invention are laminated together through welding technology.

Wherein, the heating elements in the present invention include, but are not limited to, heating elements for in-vehicle electronic devices, heating elements for computer peripheral devices, other heating elements for computer peripheral devices, and heating elements for control devices.

In comparison to prior art, the present invention comprises the top cover, the tube, and the condenser. The top cover includes the coolant cold plate and the cooling brackets located on both sides of the coolant cold plate. The coolant cold plate contains the flow channel and multiple heating elements connected to the flow channel. The coolant cold plate is equipped with the outlet and the inlet that are connected to the flow channel, with the tube at the top end. The top end of the tube connects to the condenser. This design effectively utilizes the heating elements to heat the low-temperature liquid coolant in the flow channel, causing it to absorb heat and vaporize, then rise through the tube to the condenser where it cools back to liquid form. By employing the siphon principle and generating pressure differential, the coolant circulates back into the flow channel of the coolant cold plate to absorb heat from the heating source of the heating elements. This arrangement enhances usability, eliminates the need for energy-consuming fans, promotes rapid heat dissipation, reduces costs, and significantly expands the industrial applicability while demonstrating novelty and an inventive step.

### BRIEF DESCRIPTION OF THE DRAWINGS

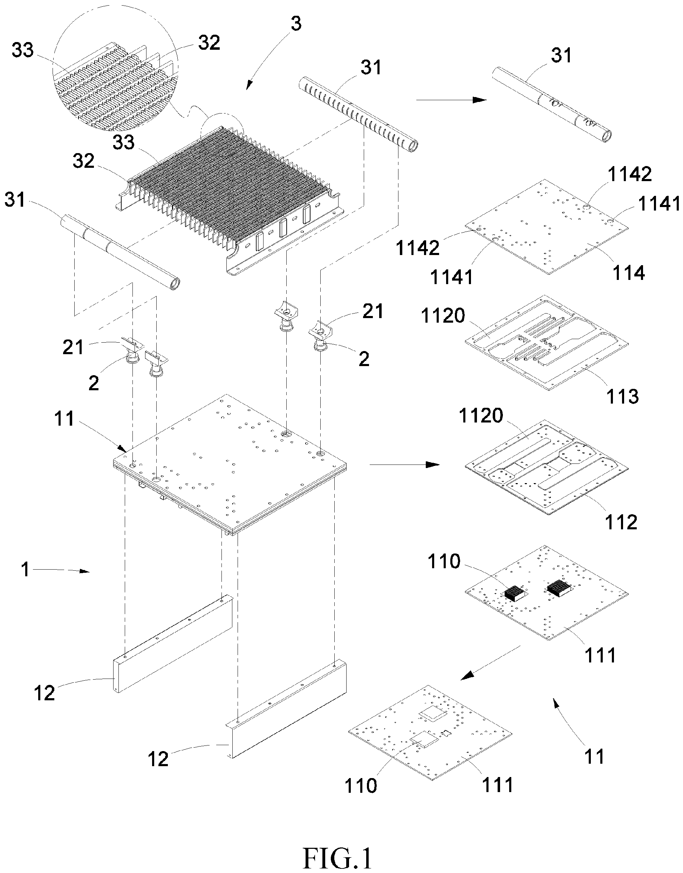

### [Designated Representative Drawing] Figure. 1

Figure 1: A perspective exploded view of the present invention.
Figure 2: A perspective assembled view of the present invention.
Figure 3: A combined cross-sectional view of the present invention.
Figure 4: An alternative combined cross-sectional view of the present invention.
Figure 5: An embodiment drawing showing the heat dissipation element vaporizing the coolant, which rises through the outlet, flows through the tube into the condenser's cooling flow channel, cools down to liquid form, then flows into another tube to descend and enter the inlet, reaching the flow channels of the coolant cold plate, utilizing the siphon principle and pressure differential to facilitate circulation.
Figure 6: A cross-sectional view from another perspective of the coolant vaporizing upon heating and cooling back to liquid form in circulation.
Figure 7: An illustrative diagram showing an embodiment of the second figure with heat sinks installed on the cooling brackets.

### [Brief Description of Reference Signs in the Representative Drawing]

1: Top cover
11: Coolant cold plate
110: Heating element
111: First-layer bottom plate
112: Second-layer composite plate
1120: Flow Channel
113: Third-layer metal plate
114: Fourth-layer top plate
1141: Outlet
1142: Inlet
12: Cooling bracket
2: Tube
21: Mounting bracket
3: Condenser
31: Cooling flow channel
32: Heat-conducting plate
33: Heat dissipation fins

### DETAILED DESCRIPTION OF THE PREFERRED EMBODIMENTS

This section provides a detailed description of the present invention in conjunction with the accompanying drawings, expressed in the form of embodiments. The illustrations used in this text are for illustrative and auxiliary purposes only, and do not necessarily represent the actual proportions and precise configurations of the invention after implementation. Therefore, the scope of the patent for the present invention should not be limited by the proportions and configurations shown in the accompanying figures, as previously stated.

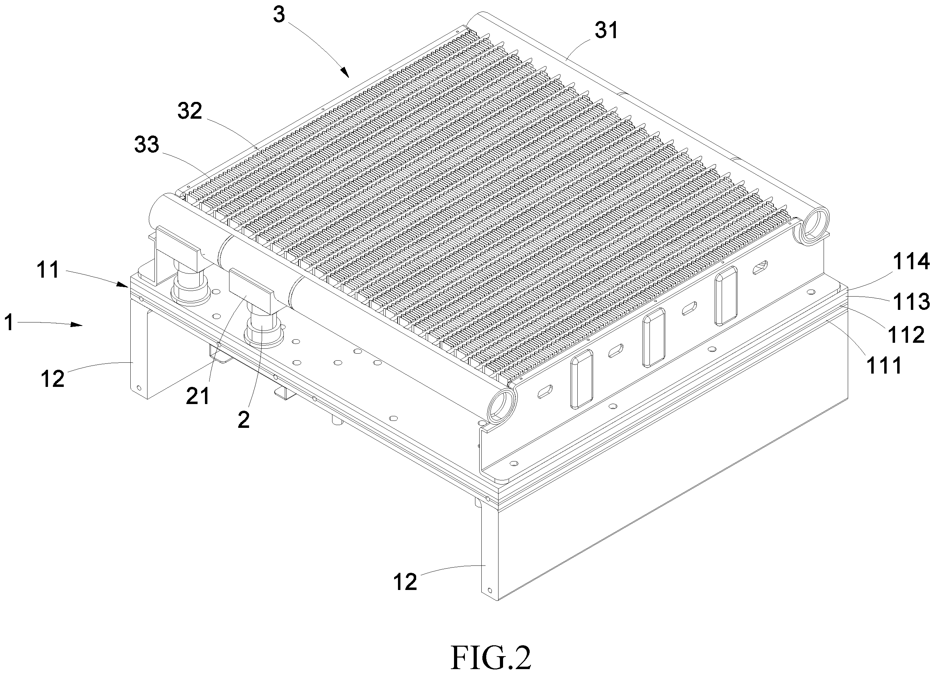

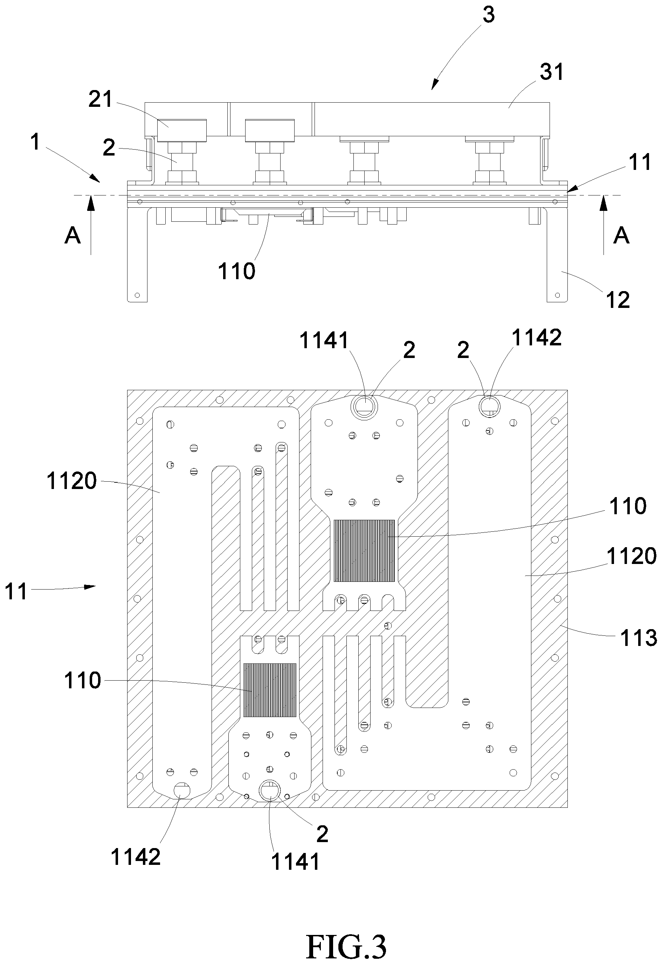

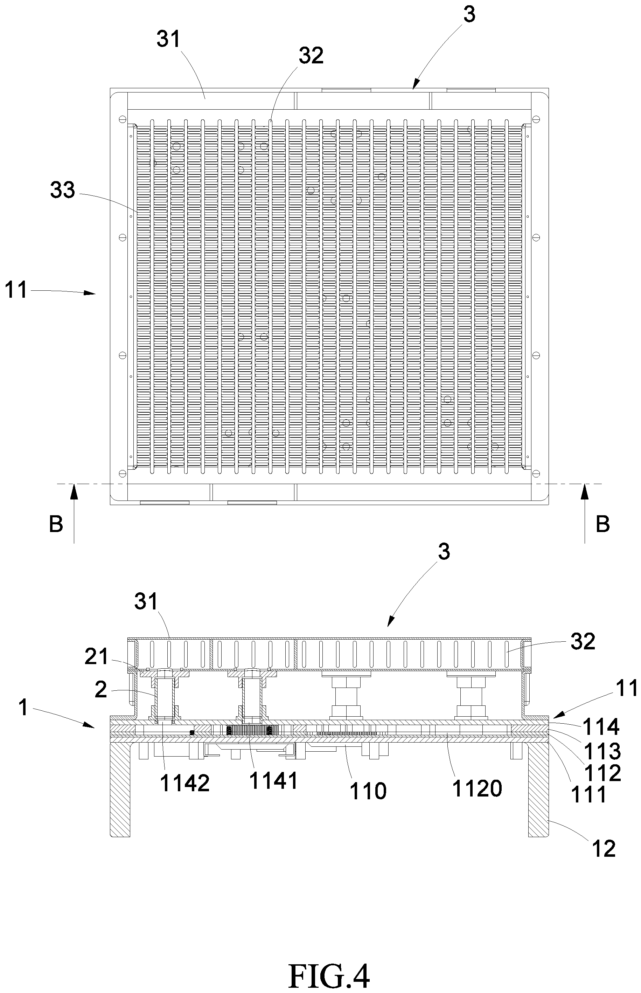

Refer to Figures 1, 2, 3, 4, 5, 6, and 7, which illustrate the perspective exploded view of the present invention, the perspective assembly view of the present invention, the combined cross-sectional view of the present invention, the alternative combined cross-sectional view of the present invention, the embodiment drawing showing the heat dissipation element vaporizing the coolant, which rises through the outlet, flows through the tube into the condenser's cooling flow channel, cools down to liquid form, then flows into another tube to descend and enter the inlet, reaching the flow channels of the coolant cold plate, utilizing the siphon principle and pressure differential to facilitate circulation, the cross-sectional view of the present invention from another angle where the coolant vaporizes upon heating and cools down to liquid form, and the embodiment drawing of the second figure showing heat sinks attached to the cooling brackets; in a preferred embodiment of the present invention, the liquid cooling heat dissipation device for electronic/computer products includes a top cover 1, multiple tubes 2, and a condenser 3.

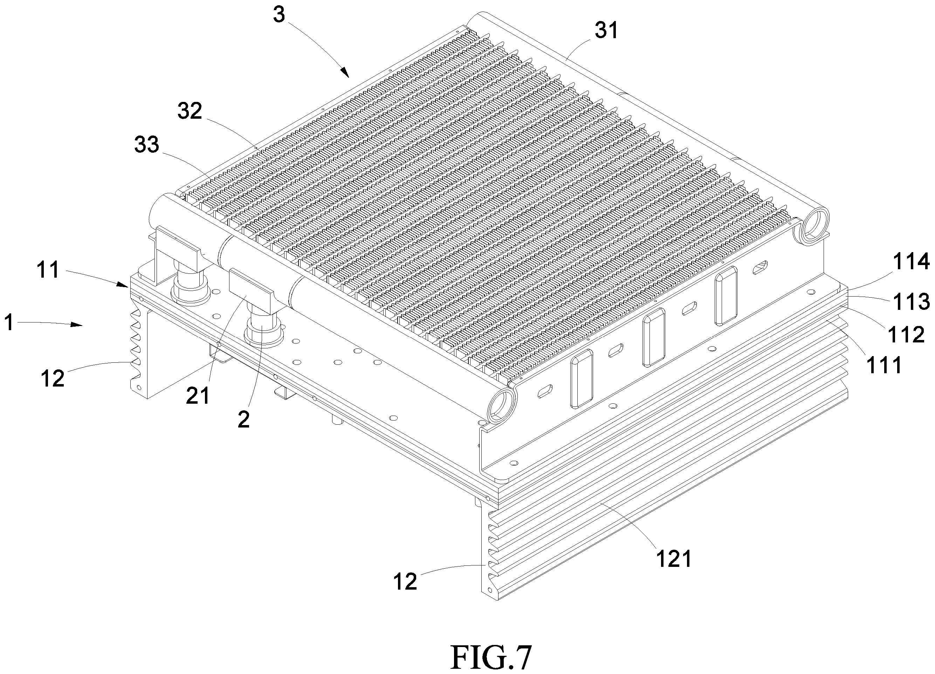

The aforementioned top cover 1 comprises a coolant cold plate 11 and two heat dissipation brackets 12. The coolant cold plate 11 includes the heat dissipation brackets 12 on both sides. The coolant cold plate 11 includes at least two sets of a flow channel 1120 accommodating the coolant and multiple heating elements 110 that connect to the flow channel 1120. In this embodiment, the heating elements 110 are high-performance CPUs or GPUs, but this does not limit this invention. The coolant cold plate 11 has two staggered ends, with each end featuring an outlet 1141 and an inlet 1142 on the same side, but positioned oppositely to those on the other end, and they are all connected to the flow channel 1120. The outer side of the cooling bracket 12 of the top cover 1 is equipped with multiple heat sinks 121 (as shown in Figure 7). In this embodiment, the heat sinks 121 are fins, but this does not limit the invention. The coolant cold plate 11 comprises a first layer base plate 111, a second layer composite plate 112, a third layer metal plate 113, and a fourth layer top plate 114 laminated together. The second layer composite plate 112 and the third layer metal plate 113 have at least two sets of flow channels 1120 accommodating the coolant. The fourth layer top plate 114 has the outlet 1141 and the inlet 1142 and is connected to the flow channels 1120 of the second layer composite plate 112 and the third layer metal plate 113. The third layer metal plate 113 of the coolant cold plate 11 in this embodiment is an aluminum plate, but this does not limit the invention. The top cover 1 in this embodiment is a metal cover, but this does not limit the invention. The metal top cover in this embodiment is an aluminum extruded cover, but this does not limit the invention. The first layer base plate 111, the second layer composite plate 112, the third layer metal plate 113, and the fourth layer top plate 114 of the coolant cold plate 11 are laminated through welding technology (as shown in Figures 1, 2, 3, and 4). In this embodiment, the heating elements 110 include heating elements for in-vehicle electronic devices, heating elements for computer peripheral devices, other heating elements for computer peripheral devices, and heating elements for control devices, but this does not limit the invention. The in-vehicle electronic devices for using the in-vehicle electronic devices heating elements may include, for example: electric vehicle charging management devices, autonomous driving computer management devices, smart fleet management devices, vehicle police management devices, public transport movement and passenger information management devices, and smart cockpit devices for commercial vehicles, but this does not limit the invention. The computer peripheral device heating elements may include, for example: mainframes, industrial computers, personal computers, laptops, and servers, but this does not limit the invention. The other computer peripheral device heating elements may include, for example: point of sale (POS) systems, kiosks, vending machines, digital electronic billboards, and autonomous mobile robots, but this does not limit the invention. The control device heating elements may include, for example: mobile license plate recognition control devices, vehicle facial recognition control devices, outdoor image monitoring devices, agricultural condition (soil moisture, temperature, light, air quality, etc.) collection and monitoring devices, livestock condition (environmental conditions of farms, animal behavior and health status, etc.) collection and monitoring devices, and smart factory automation control devices, but this does not limit the invention.

The aforementioned multiple tubes 2 are respectively installed at the outlet 1141 and the inlet 1142 of the coolant cold plate 11 on the top cover 1. The upper end of the tube 2 is equipped with a mounting bracket 21 that connects to the outlet 1141 and the inlet 1142 (as shown in figures 1, 2, 3, and 4).

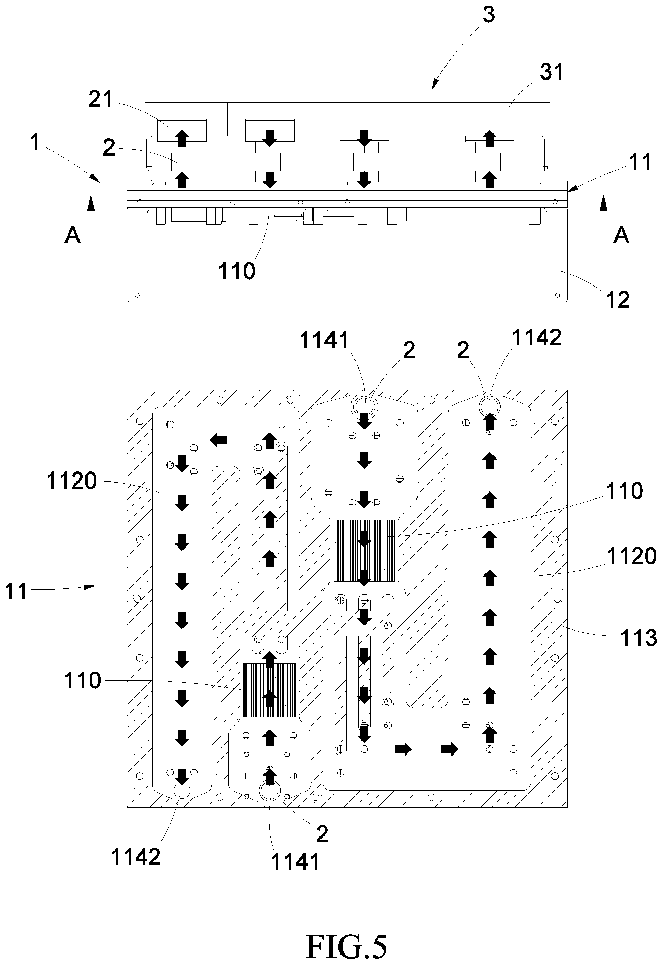

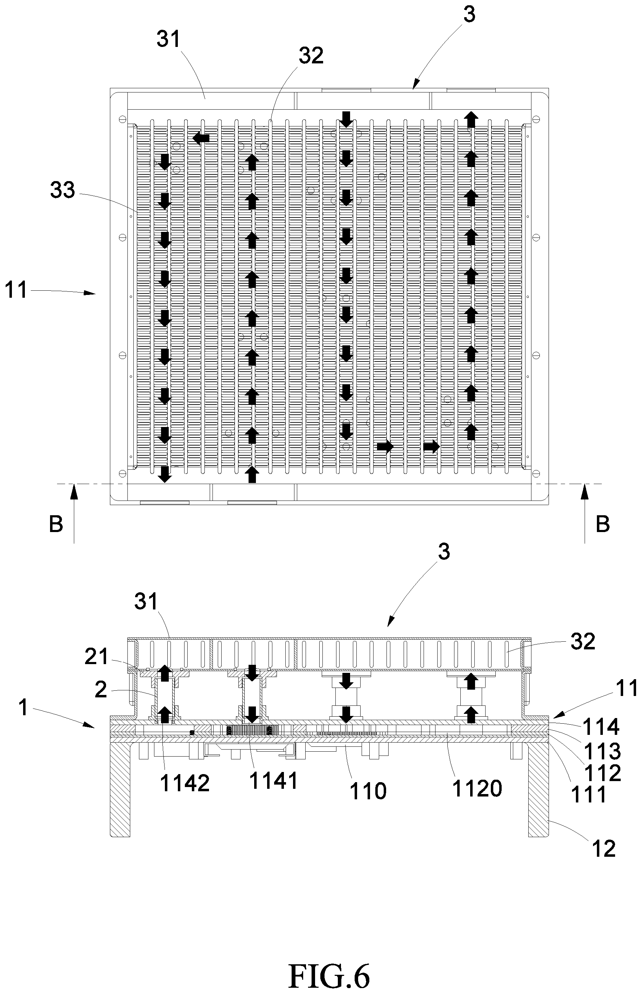

The aforementioned condenser 3 is mounted on the mounting bracket 21 of the tube 2. A side bracket 30 is located between the upper end of the coolant cold plate 11 and both sides of the condenser 3. The condenser 3 includes at least two cooling flow channels 31, multiple heat-conducting plates 32, and multiple heat dissipation fins 33. The cooling flow channels 31 are closed at both ends and are respectively bridged to connect with the mounting bracket 21 of the tube 2. The two ends of the heat-conducting plates 32 are sheathed in the cooling flow channel 31, while the heat dissipation fins 33 are connected in a bent manner between pairs of opposing heat-conducting plates 32 (as shown in Figures 1, 2, 3, and 4). The heating elements 110 heat the low-temperature liquid coolant in the flow channel 1120, causing it to absorb heat and vaporize, rising through the tube 2 to the condenser 3 and cooling back to liquid form. Utilizing the siphon principle and generating a pressure differential, the coolant circulates downward through the tube 2 and reenters the flow channel 1120 of the coolant cold plate 11 (as shown in Figures 5 and 6).

The present invention comprises an upper cover 1, a tube 2, and a condenser 3. The upper cover 1 includes the coolant cold plate 11 and the mounting brackets 12 located on both sides of the coolant cold plate 11. The coolant cold plate 11 contains the flow channel 1120 and multiple heating elements 110 that connect to the flow channel 1120. The coolant cold plate 11 is equipped with an outlet 1141 and an inlet 1142 that are connected to the flow channel 1120, with the tube 2 at the upper end. The top end of the tube 2 connects to the condenser 3, which is in communication with the tube 2. This design effectively utilizes the heating elements 110 to heat the low-temperature liquid coolant in the flow channel 1120, causing it to absorb heat and vaporize. The vapor then rises through the tube 2 to the condenser 3, where it cools back into liquid form. Utilizing the siphon principle and generating a pressure differential, the coolant circulates downward through the tube 2 and reenters the flow channel 1120 of the coolant cold plate 11 to absorb heat from the heat source of the heating elements 110. This arrangement enhances usability, eliminates the need for energy-consuming fans, promotes rapid heat dissipation, reduces costs, and significantly expands industrial applicability while demonstrating novelty and an inventive step.

Given the foregoing, it is evident that the present invention has indeed achieved the desired effects by surpassing prior technologies, and it is not easily conceived by those skilled in the art. Furthermore, this invention has not been disclosed prior to the application, and its novelty and inventive step clearly meet the requirements for a patent application. Therefore, we respectfully request your office to approve this patent application to encourage innovation, for which we would be very grateful.

The embodiments described above are merely intended to illustrate the technical ideas and features of the present invention, aiming to enable those skilled in the art to understand the content of the invention and implement it accordingly. They should not be construed as limiting the scope of the patent. Any equivalent variations or modifications made based on the spirit of the present invention should still fall within the patent scope of the present invention.

## Claims

1. A liquid cooling heat dissipation device for electronic/computer products, comprising:
a top cover, comprising a coolant cold plate and two cooling brackets, the cooling brackets located on both sides of the coolant cold plate, the coolant cold plate comprising at least two sets of a flow channel accommodating coolant and multiple heating elements connected thereto, the coolant cold plate having staggered ends, and featuring an inlet and an outlet at one end and another pair positioned oppositely at the other end, all connected to the flow channel;
multiple tubes, which are respectively installed at the outlet and inlet of the coolant cold plate on the top cover, said tubes having a mounting bracket at the upper end that connects to the outlet and inlet;
a condenser, mounted on the mounting bracket of the tube, the condenser having a side bracket located between its sides and the upper end of the coolant cold plate, comprising at least two cooling flow channels, multiple heat-conducting plates, and multiple heat dissipation fins, the cooling flow channels being closed at both ends and spanning across to connect with the mounting bracket of the tube, the heat-conducting plates being sheathed at both ends in the cooling flow channels, and the heat dissipation fins being bent and connected between pairs of opposing heat-conducting plates;
utilizing the heating elements to heat the coolant in the flow channels, causing the low-temperature liquid coolant to absorb heat and vaporize, the vaporized coolant then rising through the tubes to the condenser where it cools back to liquid form, utilizing the siphon principle and generating a pressure differential to facilitate the downward circulation of the coolant through the opposing tubes, re-entering the flow channels of the coolant cold plate.

2. The liquid cooling heat dissipation device for electronic/computer products of claim 1, wherein the outer side of the cooling brackets of the top cover is equipped with multiple heat sinks.

3. The liquid cooling heat dissipation device for electronic/computer products of claim 1, wherein the heating elements include, but are not limited to, heating elements for in-vehicle electronic devices, heating elements for computer peripheral devices, other heating elements for computer peripheral devices, and heating elements for control devices.

4. The liquid cooling heat dissipation device for electronic/computer products of claim 1 or claim 2 or claim 3, wherein the coolant cold plate comprises a first-layer bottom plate, a second-layer composite plate, a third-layer metal plate, and a fourth-layer top plate laminated together, the second-layer composite plate and the third-layer metal plate having at least two sets of flow channels accommodating coolant, and the fourth-layer top plate being provided with the outlet and the inlet, both of which are connected to the flow channels of the second-layer composite plate and the third-layer metal plate.

5. The liquid cooling heat dissipation device for electronic/computer products of claim 4, wherein the third-layer metal plate of the coolant cold plate is, but is not limited to, an aluminum plate.

6. The liquid cooling heat dissipation device for electronic/computer products of claim 1, wherein the top cover is, but is not limited to, a metal cover.

7. The liquid cooling heat dissipation device for electronic/computer products of claim 6, wherein the metal top cover is, but is not limited to, an aluminum extruded cover.

8. The liquid cooling heat dissipation device for electronic/computer products of claim 4, wherein the first-layer bottom plate, the second-layer composite plate, the third-layer metal plate, and the fourth-layer top plate of the coolant cold plate are laminated together through welding technology.
